**Europäisches Patentamt**

**European Patent Office**

**Office européen des brevets**

(19)

(11) Veröffentlichungsnummer: **0 301 264**
**B1**

(12) **EUROPÄISCHE PATENTSCHRIFT**

(45) Veröffentlichungstag der Patentschrift:
22.11.90

(51) Int. Cl.⁵: **G03F 7/32**

(21) Anmeldenummer: **88110454.1**

(22) Anmeldetag: **30.06.88**

(54) **Phenoxypropanol enthaltendes, weitgehend pH-neutrales Entwicklergemisch für Flachdruckplatten.**

(30) Priorität: **27.07.87 US 77845**

(43) Veröffentlichungstag der Anmeldung:
**01.02.89 Patentblatt 89/5**

(45) Bekanntmachung des Hinweises auf die Patenterteilung:
**22.11.90 Patentblatt 90/47**

(84) Benannte Vertragsstaaten:
**DE FR GB**

(56) Entgegenhaltungen:
**EP-A- 0 043 132**
**EP-A- 0 134 407**
**EP-A- 0 279 164**
**JP-A-62 071 958**

(73) Patentinhaber: **HOECHST CELANESE CORPORATION,**
**Route 202-206 North, Somerville, N.J. 08876(US)**

(72) Erfinder: **Hsieh, Shane, 4, Linvale Lane, Bridgewater**
**New Jersey 08807(US)**

(74) Vertreter: **Euler, Kurt Emil, Dr. et al, HOECHST AG - Werk**
**KALLE Patentabteilung**
**Postfach 3540 Rheingaustrasse 190,**
**D-6200 Wiesbaden(DE)**

## Beschreibung

Die vorliegende Erfindung betrifft ein Entwicklergemisch für lichtempfindliche Materialien, die aus Schichtträgern mit darauf aufgebrachten lichtempfindlichen Beschichtungen bestehen, genauer gesagt ein Entwicklergemisch zum Entfernen der Nichtbildstellen von belichteten, im allgemeinen negativ arbeitenden Flachdruckplatten mit lichtempfindlichen Schichten auf Diazoniumsalzbasis.

In der Vergangenheit sind verschiedene Verfahren zum Entwickeln von Druckplatten angewendet worden. Dazu zählt z. B. der Einsatz von Gemischen, die organische Lösemittel, Tenside, Salze, Säuren und andere bekannte Stoffe gelöst enthalten.

Man will möglichst ein Entwicklergemisch haben, mit dem der Entwicklungsvorgang in kurzer Zeit abgeschlossen ist. Die oleophilen Bildstellen der Druckplatte sollen farbannehmend und wasserabstoßend sein, die hydrophilen Nichtbildstellen sollen dagegen Wasser annehmen und fette Druckfarbe abstoßen.

Es ist sehr wichtig, das Lösemittel in einer Entwicklerlösung richtig zu wählen. Wenn dieses Lösemittel zum Beispiel ein guter Löser für das lichtempfindliche Gemisch selbst ist, wird es nicht genügend zwischen den belichteten und unbelichteten Bereichen differenzieren.

Es wird dann nämlich ein großer Teil der Beschichtung aus dem Bildbereich in dem Lösemittel gelöst oder stark angequollen und entfernt. Solche Druckplatten sind für die Praxis wertlos. Durch Zugabe einer großen Menge Wasser zur Herabsetzung der Konzentration des organischen Lösemittels in der Entwicklerlösung kann die Bilddifferenzierung verbessert werden. Beim Entwickeln von Druckplatten, insbesondere von negativ arbeitenden Druckplatten, kommt es dann aber dazu, daß die Harzbindemittel, wie z. B. Acetale, insbesondere Polyvinylformal, enthaltenden Nichtbildstellen in der Entwicklerlösung solvatieren, sich vom Träger ablösen und sich zu stark klebrigen, kugelförmigen Gebilden zusammenziehen. Solche solvatierten Partikel lagern sich auf den noch vom Lösemittel feuchten Bildstellen an und haften selbst nach dem Trocknen noch dauerhaft. Diese "wieder angelagerten" Bereiche sind auf der entwickelten Druckplatte nicht nur mit bloßem Auge sichtbar; sie werden beim Drucken auch von klebriger Druckfarbe abgelöst, die dann auch das darunter liegende echte Bild abzieht und leere Stellen zurückläßt, die auf dem Druckbogen als Bildlücken erscheinen.

Um dieses Problem teilweise zu lösen, werden in vielen bekannten Entwicklergemischen flüchtige Lösemittel verwendet. Man hofft, daß durch diese flüchtigen Lösemittel in der Entwicklerlösung ein Klebrigwerden des Bildes durch rasches Verdunsten verhindert wird. Der Einsatz großer Mengen an mit Wasser mischbaren, niedrig siedenden Lösemitteln, wie sie z. B. in dem in der US-A 3 954 472 beschriebenen Entwickler verwendet werden, verursacht jedoch Probleme hinsichtlich des Gesundheitsschutzes am Arbeitsplatz, der Gefährdung durch den niedrigen Flammpunkt und der Umweltverschmutzung. Durch Herabsetzung der Konzentration dieser mit Wasser mischbaren, niedrig siedenden Lösemittel können diese Probleme in der Arbeitsplatzumgebung auf ein Mindestmaß begrenzt werden, die Entwicklungsgeschwindigkeit wird jedoch nachteilig beeinflußt. Ferner wird die Klebrigkeit der Beschichtungen zwar vermindert, aber nicht vollständig beseitigt.

Zur Erhöhung der Entwicklungsgeschwindigkeit von Entwicklerlösungen mit einem geringeren Gehalt an niedrig siedenden Lösemitteln wird gelegentlich ein höhersiedendes organisches Lösemittel als Hilfsstoff zugesetzt. Solche Entwickler haben leider mehrere Nachteile, wie z.B. Toxizität, Instabilität des Entwicklers, Geruchsentwicklung oder Unfähigkeit, unerwünschte Hintergrund- bzw. Nichtbildbereiche wirksam auszuentwickeln.

In der EP-A 0 134 407 wird ein Entwickler für negativ arbeitende Reproduktionsschichten beschrieben, in dem Phenoxypropanol in Kombination mit Phosphaten, Silikaten und Boraten genannt ist. Der Entwickler weist einen pH- Wert von 8 bis 12 auf.

Für Flachdruckplatten werden im allgemeinen Träger auf Aluminiumbasis eingesetzt, die gegebenenfalls nach einer Reihe von bekannten Verfahren behandelt worden sein können, wie z.B. durch Anodisierung, Aufrauhung und Hydrophilierung. Die so vorbereiteten Träger werden mit einer lichtempfindlichen Beschichtung aus lichtempfindlicher Verbindung, Harzen als Bindemitteln, Farbmitteln, Säuren als Stabilisatoren, Tensiden und anderen gebräuchlichen Komponenten beschichtet. Zu den üblichen lichtempfindlichen Verbindungen zählen Diazoniumverbindungen, wie z.B. polymere Kondensationsprodukte von Diazoniumsalzen und photopolymerisierbare Verbindungen. Lichtempfindliche Verbindungen, Bindemittel und Druckplatten, in denen aromatische Diazoniumverbindungen verwendet werden, sind aus den US-A 3 175 906, 3 046 118, 2 063 631, 2 667 415, 3 867 147 und 3 679 419 bekannt.

Aufgabe der vorliegenden Erfindung ist es, einen Entwickler für Flachdruckplatten zu schaffen, in dem nur ein geringer Anteil toxikologisch bedenklicher organischer Lösemittel enthalten ist und der einen im wesentlichen neutralen pH-Wert aufweist, ohne daß die Wirtschaftlichkeit und Vollständigkeit der Entwicklung beeinträchtigt werden. Insgesamt sollen die aufgeführten Nachteile der aus dem Stand der Technik bekannten Entwickler vermindert bzw. verhindert werden.

Gegenstand der Erfindung ist ein Entwicklergemisch mit einem pH-Wert zwischen 6,5 und 7,5, enthaltend, jeweils bezogen auf das Gesamtgewicht des Entwicklers,

a) 0,1 bis 20,0 Gew.-% einer oder mehrerer Verbindungen aus der Gruppe umfassend Natriumoctyl, Natriumtetradecyl-, Natrium-2-ethylhexyl- und Ammoniumlaurylsulfat;

b) 0,1 bis 30,0 Gew.-% einer oder mehrerer Verbindungen aus der Gruppe umfassend die Lithiumsalze der Hydroxy- und/oder Aryl- und/oder Alkylcarbonsäuren;

c) 0,1 bis 30,0 Gew.-% einer oder mehrerer Verbindungen aus der Gruppe umfassend die Kaliumsalze der Hydroxy- und/oder Aryl- und/oder Alkylcarbonsäuren;

d) gegebenenfalls eine mit den übrigen Bestandteilen verträgliche Säure oder Base und/oder deren Salze, in jeweils zur Einstellung des pH-Wertes auf 6,5 bis 7,5 ausreichender Menge;

e) gegebenenfalls bis zu 0,05 Gew.-% eines Antischaummittels;

f) 0,5 bis 3,0 Gew.-% eines organischen, im wesentlichen aus Phenoxypropanol bestehenden Lösemittelgemisches; sowie

g) Rest zu 100,0 Gew.-% Wasser.

Gegenstand der Erfindung ist ferner ein Verfahren zur Herstellung einer Druckplatte, bei der ein Träger, auf den vorzugsweise ein negativ arbeitendes lichtempfindliches Gemisch aufgebracht wurde, zur Erzeugung eines latenten Bildes mit ausreichender aktinischer Strahlung belichtet wird und die Nichtbildstellen anschließend von dem belichteten, lichtempfindlich beschichteten Material entfernt werden durch Behandeln mit einem Entwicklergemisch mit einem pH-Wert zwischen 6,5 und 7,5, enthaltend, jeweils bezogen auf das Gesamtgewicht des Entwicklers,

a) 0,1 bis 20,0 Gew.-% einer oder mehrerer Verbindungen aus der Gruppe umfassend Natriumoctyl, Natriumtetradecyl-, Natrium-2-ethylhexyl- und Ammoniumlaurylsulfat;

b) 0,1 bis 30,0 Gew.-% einer oder mehrerer Verbindungen aus der Gruppe umfassend die Lithiumsalze der Hydroxy- und/oder Aryl- und/oder Alkylcarbonsäuren;

c) 0,1 bis 30,0 Gew.-% einer oder mehrerer Verbindungen aus der Gruppe umfassend die Kaliumsalze der Hydroxy- und/oder Aryl- und/oder Alkylcarbonsäuren;

d) gegebenenfalls eine mit den übrigen Bestandteilen verträgliche Säure oder Base und/oder deren Salze, in jeweils zur Einstellung des pH-Wertes auf 6,5 bis 7,5 ausreichender Menge;

e) gegebenenfalls bis zu 0,05 Gew.-% eines Antischaummittels;

f) 0,5 bis 3,0 Gew.-% eines organischen, im wesentlichen aus Phenoxypropanol bestehenden Lösemittelgemisches; sowie

g) Rest zu 100,0 Gew.-% Wasser.

Bei der Herstellung von negativ arbeitenden lichtempfindlichen Materialien, wie zum Beispiel Flachdruckplatten, wird zunächst eine Trägerplatte aus einer für die Herstellung von Flachdruckplatten geeigneten Aluminiumlegierung, wie Alcoa 3303 oder Alcoa 1100, die gegebenenfalls nach den üblichen Aufrauh- und/oder Ätz- und/oder Anodisierungsverfahren vorbehandelt und gegebenenfalls auch mit einer Substanz, wie z. B. Polyvinylphosphonsäure, die sich zur Herstellung von hydrophilierenden Schichten auf Flachdruckplatten eignet, behandelt worden ist, mit einem ein polymeres Diazoniumsalz oder ein Photopolymer enthaltenden lichtempfindlichen Gemisch beschichtet. Solche Gemische können ferner Harze als Bindemittel, wie z. B.

Polyvinylformalharze, Farbmittel, Säuren als Stabilisatoren, Tenside, Belichtungsindikatoren oder andere übliche Bestandteile enthalten.

Die lichtempfindliche Platte wird dann mit einer geeigneten Strahlungsquelle durch eine Maske oder eine Transparentvorlage belichtet, und die Nichtbildstellen werden anschließend durch Entwickeln von der belichteten Platte entfernt.

Das lichtempfindliche Beschichtungsgemisch wird gewöhnlich in einem Lösemittelgemisch hergestellt, das mit allen anderen Bestandteilen des Gemisches verträglich ist. Das lichtempfindliche Gemisch wird dann auf den Träger aufgebracht und das Lösemittel durch Trocknen vertrieben.

Die bei der Herstellung von lichtempfindlichen Gemischen für den hier beschriebenen Anwendungszweck am häufigsten verwendeten Diazoniumverbindungen lassen sich durch die allgemeine Formel $A-N_2^+X^-$ charakterisieren, worin A eine aromatische oder heterocyclische Gruppe und X das Anion einer Säure ist.

Beispiele für geeignete lichtempfindliche Diazoniummaterialien sind höhermolekulare Substanzen, die man zum Beispiel durch Kondensation bestimmter aromatischer Diazoniumsalze mit bestimmten aromatischen Carbonylverbindungen, z. B. mit Formaldehyd, in saurem Medium erhält, wie sie beispielsweise aus den US-A 2 063 631 und 2 667 415 bekannt sind. Eine bevorzugte Klasse von Diazoniumverbindungen ist in der US-A 3 849 392 beschrieben.

Das besonders bevorzugte Diazoniumsalz ist das Polykondensationsprodukt aus 3-Methoxy-4-diazonium-diphenylaminsulfat und 4,4'-Bis-methoxymethyl-diphenylether, ausgefällt als Mesitylensulfonat, gemäß US-A 3 849 392.

Geeignete photopolymerisierbare Gemische sind dem Fachmann gleichfalls bekannt.

Die vorliegende Erfindung stellt einen Entwickler und ein Verfahren zum Entwickeln solcher belichteten, lichtempfindlichen Materialien bereit, bei dem diese Materialien zwecks Entfernung der Nichtbildstellen mit einem Entwickler in Kontakt gebracht werden, der die oben genannten Bestandteile in wäßriger Lösung enthält.

Der pH-Wert des Gemisches liegt im wesentlichen im neutralen Bereich, d.h. zwischen 6,5 und 7,5, bevorzugt zwischen 6,5 und 7,2, insbesondere zwischen 7,0 und 7,2.

Als Tensid enthält der erfindungsgemäße Entwickler ein Alkylsulfat, das im Entwickler praktisch zu keiner Schaumbildung führt. Bevorzugt besteht diese Komponente aus einer oder mehreren der folgenden Verbindungen: Natriumoctyl-, Natriumtetradecyl-, Natrium-2-ethyl-hexyl- und Ammoniumlaurylsulfat. Das Tensid wird in einer Menge von 0,1 bis 20,0 Gew.-%, bevorzugt von 0,5 bis 15,0 Gew.-% und insbesondere von 3,0 bis 8,0 Gew.-% zugegeben, jeweils bezogen auf das Gesamtgewicht des Entwicklers.

Außerdem enthält der Entwickler eine oder mehrere Verbindungen aus der Gruppe umfassend die Lithiumsalze der Hydroxy-, Aryl- oder Alkylcarbonsäuren in einer Menge von 0,1 bis 30,0 Gew.-%, bevorzugt von 1 bis 20,0 Gew.-% und insbesondere von 5,0 bis 10,0 Gew.-%, jeweils bezogen auf das Gesamtgewicht des Entwicklers. Gut geeignet ist beispielsweise Lithiumbenzoat oder ein Salz, das durch Zugabe von Lithiumhydroxid zu einer wäßrigen Lösung der jeweiligen Carbonsäure erhalten wird.

Des weiteren enthält der Entwickler eine oder mehrere Verbindungen aus der Gruppe der Kaliumsalze der Hydroxy-, Aryl- oder Alkylcarbonsäuren in einer Menge von 0,1 bis 30,0 Gew.-%, bevorzugt 0,5 bis 20,0 Gew.-% und insbesondere von 1,0 bis 10,0 Gew.-%, jeweils bezogen auf das Gesamtgewicht des Entwicklers. Zu den typischen Vertretern dieser Gruppe von Verbindungen gehören Kaliumsorbat, -citrat, -succinat und -maleinat. Sie sind im Handel erhältlich oder können durch Zugabe von Kaliumhydroxid zu der jeweiligen Carbonsäure selbst hergestellt werden. Bevorzugt beträgt das Verhältnis von Lithiumsalz zu Kaliumsalz 1:1 oder 1:>1. Als Beispiel für Carbonsäuren, die zur Erzeugung der Lithium- und Kaliumsalze eingesetzt werden können, seien Sorbin-, Bernstein-, Benzoe-, D.L.-Äpfel-, Wein- und Citronensäure genannt.

Außerdem enthält der Entwickler 0,5 bis 3,0 Gew.-% Phenoxypropanol, jeweils bezogen auf das Gesamtgewicht des Entwicklers. Bevorzugt sind im Entwickler keine weiteren organischen Lösemittel enthalten. Bei einem Phenoxypropanolgehalt von weniger als 0,5 Gew.-% geht die Entwicklung sehr langsam vonstatten, während es bei einem Gehalt von über 3,0 Gew.-% zu unerwünschten Wiederanlagerungen von bereits entfernten Partikeln auf der Plattenoberfläche kommt. Phenoxypropanol ist z.B. unter der Bezeichnung (R)Dowanol PPH (Hersteller: Dow Chemical Company) im Handel erhältlich.

Gegebenenfalls enthält der Entwickler noch eine mit den übrigen Komponenten kompatible Säure oder Base oder deren Salze, mit deren Hilfe der pH-Wert des Entwicklers auf den erfindungsgemäß gewünschten Bereich eingestellt wird. Die Menge der jeweiligen Säure oder Base richtet sich nach den jeweiligen Erfordernissen. Geeignete Verbindungen sind beispielsweise D.L.-Glycerinsäure, Äpfelsäure, Weinsäure, Citronensäure, Galactansäure, Leuritinsäure, 8,9,15-Trihydroxypalmitinsäure sowie Alkalihydroxide.

In der bevorzugten Ausführung enthält der erfindungsgemäße Entwickler gegebenenfalls geringe Mengen eines herkömmlichen Antischaummittels, das die Verarbeitung der Druckplatten erleichtert. Sofern diese Komponente eingesetzt wird, beträgt ihr Anteil bevorzugt 0,002 bis 0,05 Gew.-%, bezogen auf das Gesamtgewicht des Entwicklers. Ein solches Antischaummittel ist beispielsweise im Handel unter der Bezeichnung DB-31 erhältlich.

Die Entwicklerlösung wird in der Praxis oft in Verarbeitungsgeräten eingesetzt, in denen sie durch abgelöste Druckplattenbestandteile verunreinigt wird. Dadurch kann es im Lauf der Zeit zu unerwünschten pH-Wert-Schwankungen kommen, und dem Entwickler wird daher gegebenenfalls noch eine Puffersubstanz zugesetzt. Durch die Puffersubstanz soll die Abweichung vom ursprünglichen pH-Wert des nicht verunreinigten Entwicklers auf einen bevorzugten Bereich von ± 2 begrenzt werden. Als Puffersubstanzen kommen beispielsweise die Alkalisalze von Citronen-, Phosphor-, Bor-, Barbitur-, Bernstein- und Phthalsäure sowie Triethanolamin und Tris(hydroxymethyl)aminoethan in Frage. Die Alkaliphosphate sind zwar besonders hochwirksame Puffersalze, doch werden sie aus Umweltgründen nicht gerne eingesetzt. Besonders bevorzugt wird erfindungsgemäß Natriumcitrat verwendet. Die Puffer werden so dosiert, daß die pH-Wert-Schwankungen auf einen Bereich von ± 2 beschränkt werden.

Als Antischaummittel wird bevorzugt ein Mittel auf Silikonbasis, z. B. (R)Dow DB-31, eingesetzt.

Neben den genannten Bestandteilen enthält das Gemisch Wasser in einer jeweils zur Herstellung einer praxisgerechten Entwicklerlösung erforderlichen Menge. Auch Filmbildner sind gegebenenfalls im Entwickler enthalten. Mit Hilfe des Entwicklers können die Nichtbildstellen eines lichtempfindlichen Materials innerhalb von zwei Minuten oder weniger praktisch vollständig entfernt werden, ohne daß dabei die Bildstellen nennenswert angegriffen werden. Von dem Material der Nichtbildstellen wird praktisch nichts auf dem lichtempfindlichen Material wiederangelagert.

Mit der vorstehend beschriebenen erfindungsgemäßen Entwicklerlösung werden der Verfahrensspielraum erweitert, Schwankungen innerhalb der Lösung reduziert und eine ausreichend schnelle Entwicklung erzielt, ohne daß dabei die Gebrauchsdauer verkürzt wird. Der Entwickler ist außerdem für zahlreiche Druckplattentypen geeignet, zu deren Herstellung unterschiedliche Sensibilisatoren und Bindemittel verwendet wurden. Das ist von großem Vorteil, da bislang in vielen Fällen eine Veränderung der Entwicklerrezeptur erforderlich ist, sobald an der jeweiligen Druckplattenzusammensetzung auch nur kleine Verbesserungen vorgenommen werden. Überdies ist der Entwickler für fast alle Verarbeitungsgeräte geeignet, ohne daß irgendwelche Maschinenschäden befürchtet werden müssen. Daneben besitzt der erfindungsgemäße Entwickler eine außergewöhnlich lange Standzeit, d.h. es können bis zu zweimal so viele Platten entwickelt werden wie mit herkömmlichen Entwicklern. Das Phenoxypropanol hat sich als umweltverträgliches Lösemittel erwiesen, durch dessen Zusatz die Nichtbildstellen ohne Schädigung der Bildstellen von der Platte entfernt werden. In anderen bekannten Entwicklern ist dagegen das umweltschädliche Phenoxyethanol als Lösemittel enthalten.

Anhand der folgenden Beispiele wird die Erfindung näher erläutert, ohne daß jedoch eine Einschränkung auf diese Beispiele stattfinden soll.

Beispiel 1

Eine negativ arbeitende Druckplatte ((R)ENCO A-30, Hersteller: Hoechst Celanese Corporation, Somerville, New Jersey, USA) wird mittels aktinischer Strahlung in bekannter Weise belichtet und anschließend mit dem folgenden Entwicklergemisch behandelt:
5,70 Gew.-% Natriumoctylsulfat,

7,10 Gew.-% Lithiumbenzoat,
2,40 Gew.-% Kaliumsorbat,
1,00 Gew.-% Natriumcitrat,
0,08 Gew.-% Citronensäure,
0,02 Gew.-% Antischaummittel DB-31,
1,90 Gew.-% Phenoxypropanol und
Rest zu 100,00 Gew.-% Wasser.

Die Platte läßt sich in einem marktüblichen Entwicklungsgerät ohne Tonen oder Wiederanlagerung von abgelösten Schichtbestandteilen sauber entwickeln.

Beispiel 2

Es wird verfahren wie in Beispiel 1, mit der Ausnahme, daß der verwendete Entwickler folgende Zusammensetzung hat:
6,00 Gew.-% Natriumoctylsulfat,
7,00 Gew.-% Lithiumbenzoat,
4,00 Gew.-% Kaliummalat,
0,02 Gew.-% Antischaummittel DB-31,
2,00 Gew.-% Phenoxypropanol und
Rest zu 100,00 Gew.-% Wasser.

Das Ergebnis entspricht dem Ergebnis von Beispiel 1.

Beispiel 3

Es wird verfahren wie in Beispiel 1, mit der Ausnahme, daß der verwendete Entwickler folgende Zusammensetzung hat:
7,50 Gew.-% Lithiumsuccinat,
1,00 Gew.-% Bernsteinsäure,
1,00 Gew.-% Kaliumhydroxid,
5,70 Gew.-% Natriumoctylsulfat,
0,02 Gew.-% Antischaummittel DB-31,
2,00 Gew.-% Phenoxypropanol und
Rest zu 100,00 Gew.-% Wasser.

Das Ergebnis entspricht dem Ergebnis von Beispiel 1.

Beispiel 4

Es wird verfahren wie in Beispiel 1, mit der Ausnahme, daß der verwendete Entwickler folgende Zusammensetzung hat:
7,50 Gew.-% Lithiumcitrat,
2,50 Gew.-% Kaliumcitrat,
0,09 Gew.-% Citronensäure,
6,00 Gew.-% Natriumoctylsulfat,
0,02 Gew.-% Antischaummittel DB-31,
2,00 Gew.-% Phenoxypropanol und
Rest zu 100,00 Gew.-% Wasser.

Das Ergebnis entspricht dem Ergebnis von Beispiel 1.

Beispiel 5

Es wird verfahren wie in Beispiel 1, mit der Ausnahme, daß der verwendete Entwickler folgende Zusammensetzung hat:

7,50 Gew.-% Lithiumbenzoat,
2,20 Gew.-% Kaliumcitrat,
5,70 Gew.-% Natriumoctylsulfat,
2 Tropfen Salzsäure,
0,02 Gew.-% Antischaummittel DB-31,
2,00 Gew.-% Phenoxypropanol und
Rest zu 100,00 Gew.-% Wasser.

Das Ergebnis entspricht dem Ergebnis von Beispiel 1.

Beispiel 6

Es wird verfahren wie in Beispiel 1, mit der Ausnahme, daß der verwendete Entwickler folgende Zusammensetzung hat:
7,50 Gew.-% Lithiumbenzoat,
1,50 Gew.-% Kaliumhydroxid,
1,50 Gew.-% D.L.-Äpfelsäure,
6,00 Gew.-% Natriumoctylsulfat,
0,02 Gew.-% Antischaummittel DB-31,
2,00 Gew.-% Phenoxypropanol und Rest zu 100,00 Gew.-% Wasser.

Das Ergebnis entspricht dem Ergebnis von Beispiel 1.

**Patentansprüche**

1. Wäßriges Entwicklergemisch mit einem pH-Wert von 6,5 bis 7,5, enthaltend, jeweils bezogen auf das Gesamtgewicht des Entwicklers,
   a) 0,1 bis 20,0 Gew.-% einer oder mehrerer Verbindungen aus der Gruppe umfassend Natriumoctyl-, Natriumtetradecyl-, Natrium-2-ethylhexyl- und Ammoniumlaurylsulfat;
   b) 0,1 bis 30,0 Gew.-% einer oder mehrerer Verbindungen aus der Gruppe umfassend die Lithiumsalze der Hydroxy- und/oder Aryl- und/oder Alkylcarbonsäuren;
   c) 0,1 bis 30,0 Gew.-% einer oder mehrerer Verbindungen aus der Gruppe umfassend die Kaliumsalze der Hydroxy- und/oder Aryl- und/oder Alkylcarbonsäuren;
   d) gegebenenfalls eine mit den übrigen Bestandteilen verträgliche Säure oder Base und/oder deren Salze, in jeweils zur Einstellung des pH-Wertes auf 6,5 bis 7,5 ausreichender Menge;
   e) gegebenenfalls bis zu 0,05 Gew.-% eines Antischaummittels;
   f) 0,5 bis 3,0 Gew.-% eines organischen, im wesentlichen aus Phenoxypropanol bestehenden Lösemittelgemisches; sowie
   g) Rest zu 100,0 Gew.-% Wasser.

2. Gemisch nach Anspruch 1, enthaltend die Komponente a) in einer Menge von 0,5 bis 15,8 Gew.-%.

3. Gemisch nach einem der Ansprüche 1 oder 2, enthaltend die Komponente b) in einer Menge von 1,0 bis 20,0 Gew.-%.

4. Gemisch nach einem der Ansprüche 1 bis 3, enthaltend die Komponente c) in einer Menge von 0,5 bis 20,0 Gew.-%.

5. Gemisch nach Anspruch 1, enthaltend die Komponente a) in einer Menge von 3,0 bis 8,0 Gew.-%,

die Komponente b) in einer Menge von 5,0 bis 10,0 Gew.-%, die Komponente c) in einer Menge von 1,0 bis 10,0 Gew.-%.

6. Gemisch nach einem der Ansprüche 1 bis 5, enthaltend als Komponente a) Natriumoctylsulfat.

7. Gemisch nach einem der Ansprüche 1 bis 6, enthaltend als Komponente b) Lithiumbenzoat.

8. Gemisch nach einem der Ansprüche 1 bis 7, enthaltend als Komponente c) Kaliumsorbat.

9. Gemisch nach einem der Ansprüche 1 bis 8, enthaltend als Komponente d) Citronensäure.

10. Gemisch nach einem der Ansprüche 1 bis 9, enthaltend als Komponente d) eine oder mehrere Verbindungen aus der Gruppe der Alkalimetallsalze von Zitronensäure, Phosphorsäure, Borsäure, Barbitursäure, Succinsäure, Phthalsäure, Triethanolamin und Tris(hydroxymethyl)aminoethane.

11. Gemisch nach Anspruch 10, enthaltend als Komponente d) Natriumcitrat.

12. Gemisch nach einem der Ansprüche 1 bis 10, enthaltend Natriumoctylsulfat in einer Menge von 3,0 bis 8,0 Gew.-%, Lithiumbenzoat in einer Menge von 5,0 bis 10,0 Gew.-%, Kaliumsorbat in einer Menge von 1,0 bis 10,0 Gew.-% und Citronensäure.

13. Verfahren zur Herstellung einer Druckplatte, in dem man eine auf einem gegebenenfalls aufgerauhten und/oder anodisierten und/oder hydrophilierten Träger befindliche, vorzugsweise negativ arbeitende, lichtempfindliche Schicht belichtet und anschließend mit dem Entwickler gemäß Anspruch 1 behandelt.

**Claims**

1. Aqueous developer mixture having a pH of 6.5 to 7.5 and containing, in each case relative to the total amount of the developer,
   a) 0.1 to 20.0% by weight of one or more compounds from the group comprising sodium octyl, sodium tetradecyl, sodium 2-ethylhexyl and ammonium lauryl sulphate;
   b) 0.1 to 30.0 % by weight of one or more compounds from the group comprising the lithium salts of hydroxy- and/or aryl- and/or alkylcarboxylic acids;
   c) 0.1 to 30.0% by weight of one or more compounds from the group comprising the potassium salts of hydroxy- and/or aryl- and/or alkylcarboxylic acids;
   d) if desired, an acid or base and/or salts thereof compatible with the remaining components, in an amount which, in each case, is sufficient for adjusting the pH to 6.5 to 7.5;
   e) if desired, up to 0.05% by weight of an antifoaming agent;
   f) 0.5 to 3.0% by weight of an organic solvent mixture essentially consisting of phenoxypropanol;
   g) the balance being water to make up 100% by weight.

2. Mixture according to claim 1, containing the component a) in an amount of 0.5 to 15.8% by weight.

3. Mixture according to one of claims 1 or 2, containing component b) in an amount of 1.0 to 20.0% by weight.

4. Mixture according to one of claims 1 to 3, containing component c) in an amount of 0.5 to 20.0% by weight.

5. Mixture according to claim 1, containing component a) in an amount of 3.0 to 8.0% by weight, component b) in an amount of 5.0 to 10.0% by weight, component c) in an amount of 1.0 to 10.0% by weight.

6. Mixture according to one of claims 1 to 5, containing as component a) sodium octyl sulphate.

7. Mixture according to one of claims 1 to 6, containing as component b) lithium benzoate.

8. Mixture according to one of claims 1 to 7, containing as component c) potassium sorbate.

9. Mixture according to one of claims 1 to 8, containing as component d) citric acid.

10. Mixture according to one of claims 1 to 9, containing as component d) one or more compounds from the group of alkalimetal salts of citric acid, phosphoric acid, boric acid, barbituric acid, succinic acid, phthalic acid, triethanolamin and tris-(hydroxymethyl)aminoethane.

11. Mixture according to claim 10, containing as component d) sodium citrate.

12. Mixture according to one of claims 1 to 10, containing sodium octyl sulphate in an amount of 3.0 to 8.0% by weight, lithium benzoate in an amount of 5.0 to 10.0% by weight, potassium sulphate in an amount of 1.0 to 10.0% by weight and citric acid.

13. Process for the production of a printing plate, in which a photo-sensitive, preferably negative-working layer which is present on a support which, if desired, has been roughened and/or anodized and/or made hydrophilic, is exposed and then treated with the developer according to claim 1.

**Revendications**

1. Mélange développateur aqueux de pH 6,5–7,5 contenant, chaque fois rapporté au poids total du développateur,
   a) 0,1 à 20,0% en poids d'un ou de plusieurs composés du groupe comprenant l'octylsulfate de sodium, le tétradécylsulfate de sodium, le 2-éthylhexylsulfate de sodium et le laurylsulfate d'ammonium;
   b) 0,1 à 30,0% en poids d'un ou de plusieurs composés du groupe comprenant les sels de lithium des acides hydroxy- et/ou aryl- et/ou alkylcarboxyliques;
   c) 0,1 à 30,0% en poids d'un ou plusieurs composés du groupe comprenant les sels de potassium des acides hydroxy- et/ou aryl- et/ou alkylcarboxyliques;
   d) éventuellement un acide ou une base et/ou leurs sels compatibles avec les autres constituants, chaque fois en une quantité suffisante pour que le pH soit fixé à 6,5 à 7,5;
   e) éventuellement jusqu'à 0,05% en poids d'un antimousse;
   f) 0,5 à 3,0% en poids d'un mélange organique de solvants comprenant essentiellement du phénoxypropanol; ainsi que
   g) complément à 100,0% en poids d'eau.

2. Mélange selon la revendication 1, renfermant le composant a) en une proportion de 0,5 a 15,8% en poids.

3. Mélange selon l'une des revendications 1 ou 2, renfermant le composant b) en une proportion de 1,0 à 20,0% en poids.

4. Melange selon l'une des revendications 1 à 3, renfermant le composant c) en une proportion de 0,5 à 20,0% en poids.

5. Mélange selon la revendication 1, renfermant le composant a) en une proportion de 3,0 à 8,0% en poids, le composant b) en une proportion de 5,0 à 10,0% en poids, le composant c) en une proportion de 1,0 à 10,0% en poids.

6. Melange selon l'une des revendications 1 à 5, renfermant comme composant a) l'octylsulfate de sodium.

7. Mélange selon l'une des revendications 1 à 6, renfermant comme composant b) le benzoate de lithium.

8. Melange selon l'une des revendications 1 à 7, renfermant comme composant c) le sorbate de potassium.

9. Mélange selon l'une des revendications 1 à 8, renfermant comme composant d) l'acide citrique.

10. Mélange selon l'une des revendications 1 à 9, renfermant comme composant d) un ou plusieurs des composés du groupe des sels de métaux alcalins des acides citrique, phosphorique, borique, barbiturique, succinique et phtalique la triéthanolamine et tris(hydroxyméthyl)aminoéthane.

11. Mélange selon la revendication 10, renfermant comme composant d) le citrate de sodium.

12. Mélange selon l'une des revendications 1 à 10, renfermant l'octylsulfate de sodium en une proportion de 3,0 à 8,0% en poids, le benzoate de lithium en une proportion de 5,0 à 10,0% en poids, le sorbate de potassium en une quantité de 1,0 à 10,0% en poids et de l'acide citrique.

13. Procéde de fabrication d'une plaque d'impression, dans lequel on expose une couche photosensible, travaillant de préférence en négatif, déposée sur un support éventuellement grainé et/ou anodisé et/ou hydrophilisé, puis on la traite avec le développateur selon la revendication 1.